# EUROPEAN PATENT APPLICATION

(11) **EP 2 521 266 A2**
(43) Date of publication of application: **07.11.2012**
(21) Application number: 12166822.2
(22) Date of filing: 04.05.2012
(51) Int. Cl.: H03K 19/0185

(54) **Driver with impedance control**

(30) Priority: 05.05.2011 US 201113101862
(71) Applicant: Apple Inc., Cupertino, CA 95014 (US)
(72) Inventor: Scott, Gregory S., Cupertino, CA 95014 (US); von Kaenel, Vincent R., Cupertino, CA 95014 (US)
(74) Representative: Lang, Johannes

(57) **Abstract**

An integrated circuit (IC) (100) may be configured to communicate signals to an external device (*e.g.,* a memory) (120) via a driver (140). The driver may include a plurality of driver circuits arranged in parallel with respect to each other. Each driver circuit in turn may include a plurality of driver sub-circuits. Based, for example, on the load presented by the external device (120) and/or operating conditions of the IC (100), a control circuit (180) may provide signals that enable individual ones of driver circuits to result in a selected driver strength. The control circuit (180) may also provide impedance control signals that enable or disable individual sub-circuits within one or more driver circuit, to thereby control the output impedance of each such driver circuit.

## Description

### BACKGROUND

### Field of the Invention

This invention is related to the field of integrated circuits and, more particularly, to driver circuits.

### Description of the Related Art

Integrated circuits (ICs) generally include a core circuit that implements the various operations that the IC is designed to perform, a driver circuit that drives output signals from the core circuit to an external circuit, and a receiver circuit that receives input signals from the external circuit and provides the received signals to the core circuit. The driver and receiver circuitry buffer and isolate the core circuit from the external circuit, thus handling the larger loads, higher current flows, higher voltages, noise, etc. that are typically involved in external communications.

In some embodiments, the driver circuits can be required to provide a specified output impedance. For example, driver circuits for signals that are part of an industry standard interface may be required to provide an output impedance that is specified by the standard. The output impedance can be required to be a specified value, within a specified tolerance, across a range of process conditions, temperature conditions, and supply voltage conditions.

### SUMMARY

An integrated circuit (IC) may be configured to communicate signals to an external device (*e.g.*, a memory) via drivers. Each driver may include multiple driver circuits arranged in parallel with respect to each other. Each driver circuit may in turn include multiple driver sub-circuits. Based, for example, on the load presented by the external device and/or the design of the external device, the interconnect between the IC and the external device, the presence or absence of termination, etc., a control circuit may provide signals that enable individual ones of driver circuits to result in a selected driver strength (or, equivalently, a selected driver impedance). The control circuit may also provide impedance control signals that enable or disable individual sub-circuits within one or more driver circuit, to thereby control the output impedance of each such driver circuit to account for variations in process, temperature, and supply voltage.

In some embodiments, a driver circuit may include a first sub-circuit having a first pull-up transistor, a first pull-down transistor coupled to the first pull-up transistor at a first node, and a first resistor coupled between the first node and an output pad or pin. The driver circuit may also include a second sub-circuit having a second pull-up transistor, a second pull-down transistor coupled to the second pull-up transistor at a second node, and a second resistor coupled between the second node and the same output pad or pin. Additionally or alternatively, the driver circuit may include several other similarly configured sub-circuits. By selectively enabling sub-circuits in the driver circuit, a desired output impedance for the driver circuit may be realized (or at least approximated within the granularity available via parallel combinations of the sub-circuits.

In certain embodiments, the resistance of a first resistor may be different from the resistance of a second resistor. For example, across various sub-circuits of the same driver circuit, the resistors may be designed with "binary weighting," such that the second resistor is approximately twice the size of the first resistor, a third resistor is approximately twice the size of the second resistor (and four times the size of the first resistor), and so on. Moreover, each sub-circuit may be configured such that each resistor provides approximately 80% of the output impedance of that sub-circuit, and each of the pull-up and pull-down transistors provides the remaining 20%.

In some embodiments, variations in the load of the external device (coupled to the output pad or pin) and/or in the operating conditions of the IC (*e.g.*, temperature, process speed, voltage, etc.) may prompt the control circuit to issue impedance control signals which enable or disable individual ones of the driver sub-circuits so as to maintain a desired output impedance.

In other embodiments, a method may include determining a programmable drive strength of an interface circuit having multiple driver circuits and enabling a subset of the driver circuits based, at least in part, on the programmable drive strength. The method may also include setting, based at least in part on an operating condition of the interface circuit, an impedance of one or more driver sub-circuits within the subset of enabled driver circuits. In some cases, adjusting the impedance may include enabling different ones of the pull-up or pull-down transistors of the one or more driver sub-circuits within the driver circuit. Furthermore, enabling the different ones of the pull-up or pull-down transistors may include independently enabling a different number of pull-up and pull-down transistors in each driver circuit for the same signal.

### BRIEF DESCRIPTION OF THE DRAWINGS

The following detailed description makes reference to the accompanying drawings, which are now briefly described.

FIG. 1 is a block diagram of an integrated circuit and external device according to some embodiments.

FIG. 2 is a block diagram of a driver according to some embodiments.

FIG. 3 is a block diagram of a main driver circuit including a plurality of driver circuits according to some embodiments.

FIG. 4 is a circuit diagram of a driver circuit including a plurality of driver sub-circuits according to some embodiments.

FIG. 5 is a flowchart of a method according to some embodiments.

FIG. 6 is a block diagram of a system according to some embodiments.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the intention is to cover all modifications, equivalents and alternatives falling within the spirit and scope of the present invention as defined by the appended claims. The headings used herein are for organizational purposes only and are not meant to be used to limit the scope of the description. As used throughout this application, the word "may" is used in a permissive sense (*i.e.*, meaning having the potential to), rather than the mandatory sense (*i.e.*, meaning must). Similarly, the words "include," "including," and "includes" mean including, but not limited to.

Various units, circuits, or other components may be described as "configured to" perform a task or tasks. In such contexts, "configured to" is a broad recitation of structure generally meaning "having circuitry that" performs the task or tasks during operation. As such, the unit/circuit/component can be configured to perform the task even when the unit/circuit/component is not currently on. In general, the circuitry that forms the structure corresponding to "configured to" may include hardware circuits. Similarly, various units/circuits/components may be described as performing a task or tasks, for convenience in the description. Such descriptions should be interpreted as including the phrase "configured to." Reciting a unit/circuit/component that is configured to perform one or more tasks is expressly intended not to invoke 35 U.S.C. § 112, ¶6 interpretation for that unit/circuit/component.

### DETAILED DESCRIPTION OF EMBODIMENTS

### Overview

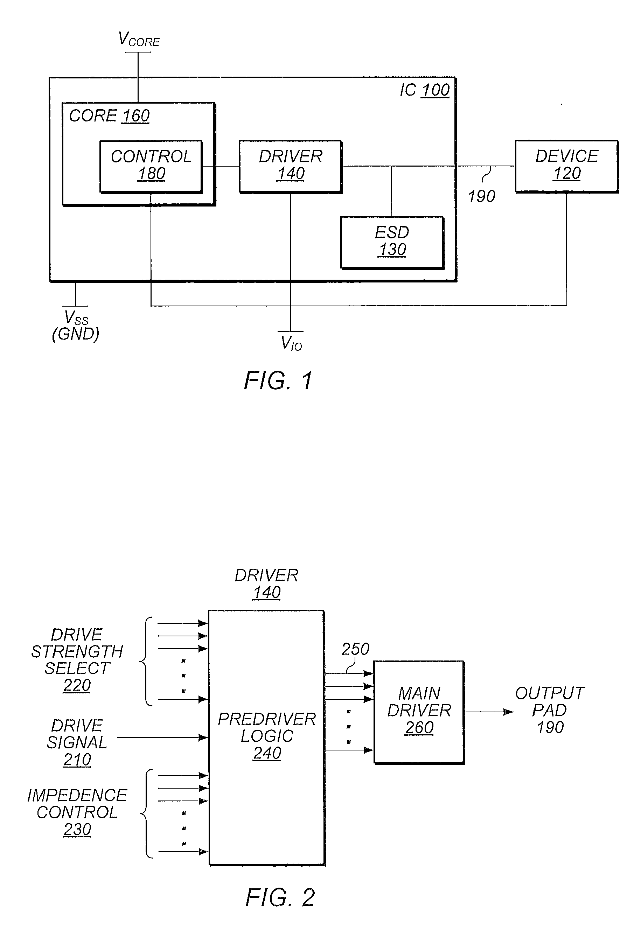

Turning now to FIG. 1, a block diagram of integrated circuit (IC) 100 and external device 120 is shown according to some embodiments. Integrated circuit 100 includes output pin or pad 190 to which device 120 is coupled (*e.g.*, via a conductor on a board to which integrated circuit 100 and external device 120 may be mounted, via a connector cable, etc.). Driver circuit 140 of integrated circuit 100 is also connected to output pad 190. Integrated circuit 100 further includes core circuitry 160, which in turn includes control circuit 180 coupled to driver circuit 140. Integrated circuit 100 also includes electrostatic discharge (ESD) protection circuit 130 coupled to output pin 190. In some embodiments, control circuit 180 may provide one or more drive signals, driver strength selection signals, impedance control signals, and/or reference voltages to driver circuit 140.

Driver circuit 140 may be coupled to receive the one or more drive signals from the control circuit 180, and may be configured to drive its output at pin 190 "high" ("pull-up") or "low" ("pull-down") to allow integrated circuit 100 to communicate with external device 120. Generally, a drive signal may be considered to be asserted in either the high state ("pull-up") or the low state ("pull-down"), and deasserted in another state (*i.e.*, "tristated"). In some embodiments, driver circuit 140 may not actively drive its output when placed in a "tristated" configuration.

As illustrated, driver circuit 140 receives supply voltage V_{IO} that is used to communicate with external device 120 at output pin 190, and core circuitry 160 is provided supply voltage V_{core}. External device 120 is also provided V_{IO}, Integrated circuit 100 is further supplied V_{SS} (*e.g.*, ground) to which the V_{IO} and V_{core} voltages are referenced. In some cases, V_{IO} may be higher than V_{core} voltage during operation. For instance, in low-power applications, V_{IO} may be approximately 1.2 volts. In other cases, V_{IO} may be approximately 3.3 volts, and V_{core} may be approximately 1.8 volts (or less, such as 1.1 volts or even less than 1 volt). While FIG. 1 illustrates external device 120 having the same supply voltage as driver circuit 14 (V_{IO}), other embodiments may have different supply voltages for device 120 and driver circuit 140. Additionally, in some embodiments, the V_{SS} voltage for core circuit 160 may be different than the V_{SS} supplied to driver circuit 140.

Core circuit 160 operates with V_{core} supply voltage, and thus the drive signals generated by core circuit 160 generally swing between V_{SS} and V_{core}. Driver circuit 140 may receive these drive signals and drive output 190 to V_{IO} (in response to an assertion of a pull-up signal) or to V_{SS} (in response to an assertion of a pull-down signal). In some embodiments, control circuit 180 may include one or more level shifters to shift signals that are supplied to the driver circuit 140. For example, a pull-up signal may be shifted so that it swings between V_{IO} and a voltage that is higher than V_{SS}. Level shifting may be user to control transistors in the driver circuit 140 without a voltage drop across its transistor's terminals that would exceed specifications. In such embodiments, control circuit 180 may also be coupled to receive the V_{IO} voltage, as illustrated in FIG. 1. In other embodiments, however, level shifter circuitry may be included in driver circuit 140 and control circuit 180 may not be coupled to receive the V_{IO} voltage. In still other embodiments, V_{IO} and V_{core} may be equal and thus no level shifting may be needed.

Control circuit 180 is configured to control driver circuit 140. For example, control circuit 180 may be programmable (*e.g.,* in a register) to pull up, pull down, or tristate the output of driver circuit 140. Software may write the register to drive these desired values. Additionally or alternatively, control circuit 180 may control the output of driver circuit 140 automatically according to an interface specification for external device 120. Moreover, control circuit 180 may generate a reference voltage for driver circuit 140 (not shown). For example, such reference voltage may include V_{core}, or may be generated from V_{core} (*e.g.*, using a band gap generator, etc.). In some embodiments, output pin 190 may be a general purpose I/O (GPIO) pin connected to any external device and controlled by software.

While output pin 190 is illustrated explicitly in FIG. 1 as a single pin, there may be multiple output pins of integrated circuit 100 that are coupled to device 120, and/or there may be additional pins to which other devices are coupled. Output pin 190 may be an input/output pin (*e.g.,* if a receiver circuit is also coupled to the output pin), and there may also be input pins having additional receiver circuits coupled to the input pins. Other driver circuits similar to driver circuit 140 may be used for pins on which the voltages used to communicate are V_{IO} voltages. Other pins may use V_{core} voltages for communication, and thus may use different types of driver circuits, as desired.

In some cases, driver circuitry 160 may be used within integrated circuit 100, for example, if integrated circuit 100 supports multiple voltage domains within core circuitry 160. And, in some embodiments, external device 120 may be integrated into integrated circuit 100; but may be external to core circuitry 160 and its V_{core} voltage domain.

Core circuitry 160 may generally include circuitry that implements various logical operations that integrated circuit 100 is designed to perform. For example, if the design includes one or more processors, core circuitry 16 may include circuitry that implements the processor operation (*e.g.*, instruction fetch, decode, execution, and result write, etc.). Such processors may include general purpose processors and/or graphics processors in various embodiments. If the design includes a bridge to a peripheral interface, for example, core circuitry 160 may include the circuitry that implements the bridge operation. If the design includes other communication features such as packet interfaces, network interfaces, etc., core circuitry 160 may include circuitry implementing the corresponding features. Integrated circuit 100 may generally be designed to provide any set of operations. Generally, core circuitry 160 may comprise any combination of one or more of the following: memory arrays, combinatorial logic, state machines, flops, registers, other clocked storage devices, custom logic circuits, etc.

In some embodiments, the system shown in FIG. 1 may be employed in microprocessors, microcontrollers, memories, systems-on-a-chip (SoCs), application-specific integrated circuits (ASICs)-or any other type of digital or analog IC, as well as microelectromechanical systems (MEMS). For example, in an embodiment, IC 100 may be a memory interface and external device 120 may be a memory. Examples of electronic devices that may include one or more ICs designed using the techniques described herein include, but are not limited to, desktop computers, laptop computers, tablets, network appliances, mobile phones, personal digital assistants (PDAs), global positioning systems (GPS), e-book readers, televisions, video game consoles, electronic control units, appliances, or any other electronic devices.

### Driver Circuit

Turning now to FIG. 2, a block diagram of driver circuit 140 is depicted according to some embodiments. As illustrated, driver circuit 140 is coupled to receive one or more drive signals 210, drive strength select signals 220, and impedance control signals 230. These signals may generally be processed by predriver logic circuit 240, and one or more processed signals 250 may be passed on to main driver circuit 260. Main driver circuit 260 then provides an output at output pin or pad 190. In some embodiments, predriver logic circuit 240 may include logic gates (*e.g.*, AND, OR, NOT, XOR, XNOR) that process and/or condition input signals 210-230 to produce one or more processed signals 250 that enable and/or reconfigure one or more driver circuits and/or sub-circuits within main driver 260.

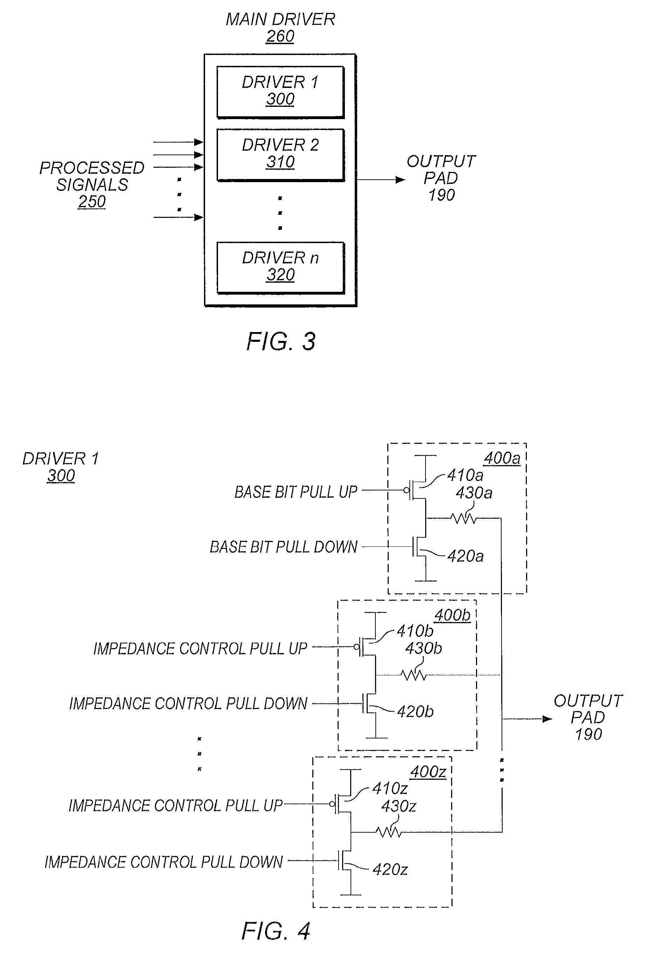

FIG. 3 shows a block diagram of main driver 260 according to some embodiments. As previously described, main driver 260 receives processed signals 250 from predriver logic circuit 240. Main driver 260 may include any suitable number of driver circuits 300-320. In some embodiments, driver circuits 300-320 are coupled to each other in a parallel configuration. Accordingly, various combinations of driver circuits 300-320 may provide programmable drive strengths. For example, drive strength select signals 220, once processed into processed signals 250 by predriver logic 240, may determine which of driver circuits 300-320 are enabled to provide a particular drive strength.

In an illustrative, non-limiting embodiment, main driver 260 includes six (6) driver circuits 300-320, each driver circuit having approximately the same impedance (*e.g.,* 240 Ω) and provides three selectable drive strengths (*e.g.,* 60, 48, and 40 Ω). In operation, when four (4) of the six driver circuits are enabled, the drive strength of main driver 260 is 60 Ω. Adding a fifth driver circuit in parallel with the other four drive circuits results in a selected drive strength of 48 Ω. And adding yet a sixth driver circuit yields a selected drive strength of 40 Ω. In this manner, the drive strength of main driver 260 may be selected by control circuit 180 using drive strength select signals 220.

In addition to providing programmable drive strength, driver circuits within main driver 260 may also provide impedance adjustment/control, as described in more detail below. That is, while the drive strength control may be programmable to selected a desired drive strength, the actual drive strength achieved in response to the programmed strength may vary due to variations in semiconductor fabrication process, operating temperature, and operating voltage. The main driver 260 and more particularly each driver circuit 300-210 may support impedance control to adjust the actual impedance over the various operating conditions.

### Impedance Adjustment

Turning now to FIG. 4, a circuit diagram of a driver circuit (*e.g.*, one of driver circuits 300-320) within main driver 260 is depicted according to some embodiments. Other driver circuits 300-320 may be similar. As illustrated, driver circuit 300 includes driver sub-circuits 400a-z coupled in parallel. Each of sub-circuits 400a-z is configured to receive a pair of signals and to provide an output to output pin 190. As illustrated, each of sub-circuits 400a-z includes a pull-up transistor (410a-z), a pull-down transistor (420a-z) coupled to the pull-up transistor at a node, and a resistor (430a-z) coupled between the node and output pad 190. Generally, driver circuit 300 may include any number of sub-circuits 400a-z. For example, in some embodiments, driver circuit 300 includes four (4) such sub-circuits.

As illustrated, pull-up transistors 410a-z are p-type metal-oxide-semiconductor (PMOS) transistors, pull-down transistors 420a-z are n-type MOS (NMOS) transistors, and resistors 430a-z are polysilicon resistors ("poly resistors"). In some embodiments, poly resistors 430a-z may be sized to be approximately 10x the size of the minimum semiconductor feature or dimension so as to avoid processing variations as well as to support current density restrictions. Thus, the poly resistors 430a-z may be resistant to variation due to variations in the semiconductor fabrication process used to manufacture the integrated circuit 100. In other embodiments, other types of semiconductor devices may be used that achieve similar functionality as described herein. For example, instead of polysilicon resistors, one or more of sub-circuits 400a-z may include diffused resistors, ion-implanted resistors, or thin-film resistors. Furthermore, transistors 410a-z and 420a-z may include any suitable type of transistor, including, for example, field-effect transistors, metal-oxide semiconductor transistors, etc.

Still referring to FIG. 4, at least one of base bit pull-up signal or base bit pull-down signal of sub-circuit 400a is turned on so long as driver circuit 300 is enabled and actively driving. Specifically, when both the base bit pull-up signal and the base bit pull-down signal are 0, pull-up transistor 410a is turned on and pull-down transistor 420a is turned off-*i.e.,* sub-circuit 400a is "pulling up." When both the base bit pull-up signal and the base bit pull-down signal are 1, pull-up transistor 410a is turned off and pull-down transistor 420a is turned on-*i.e*., sub-circuit 400a is "pulling down." On the other hand, if base bit pull-up signal is 1 and base bit pull-down signal are 0, both pull-up and pull-down transistors 410a and 420a are turned off-*i.e.,* sub-circuit 400a is "tristated."

Supplementary pull up and pull down signals may be input into other sub-circuits 400b-z of driver circuit 300 in response to impedance control signals received by main driver 260. For example, a resulting series resistance of pull-up transistor 410a with resistor 430a of sub-circuit 400a may be configured to result in a specified output impedance under a particular operating condition (*e.g.*, process speed, resistance, voltage, temperature, or combinations thereof). Also, a series resistance of pull-up transistor 410b and resistor 430b may be configured such that, when sub-circuit 400b is enabled in parallel with sub-circuit 400a, driver circuit 300 produces a different output impedance at output 190.

In some embodiments, each of resistors 430a-z has a resistance approximately 4 times larger than the resistance of its respective pull-up or pull down transistor 410a-z and 420a-z. In other words, resistor 430a may be designed such that it is responsible for approximately 80% of the series resistance of the combination of resistor 430a with pull-up transistor 410a and/or the combination of resistor 430a with pull-down transistor 420a. Furthermore, in some embodiments resistors 430a-z may be designed using "binary weighting" (*e.g.*, 1x, 2x, 4x, 8x, 16x, etc.). For example, resistor 430b may have a resistance that is approximately twice the resistance of resistor 430a, resistor 430c (not shown) may have a resistance that is approximately four times the resistance of resistor 430a (and twice that of resistor 430b), resistor 430d (not shown) may have a resistance that is approximately eight times the resistance of resistor 430a (twice that of resistor 430c and four times that of resistor 430b), and so on. Additionally or alternatively, sub-circuits 400a-z may be designed such that the series resistance of each sub-circuit (in a pull-up and/or pull-down configuration) is binary weighted with respect to other (*e.g.*, preceding) sub-circuits.

By various combinations of the sub-circuits 400a-z, the impedance presented by the driver 300 may be tuned to adjust for variations in the impedance supplied by the driver 300. At any given point in time, the configuration of sub-circuits 400a-z may account for the current operating temperature and voltage, and thus the impedance supplied by the driver 300 (and ultimately by the main driver 260) may be adjusted to track the desired output impedance of the driver.

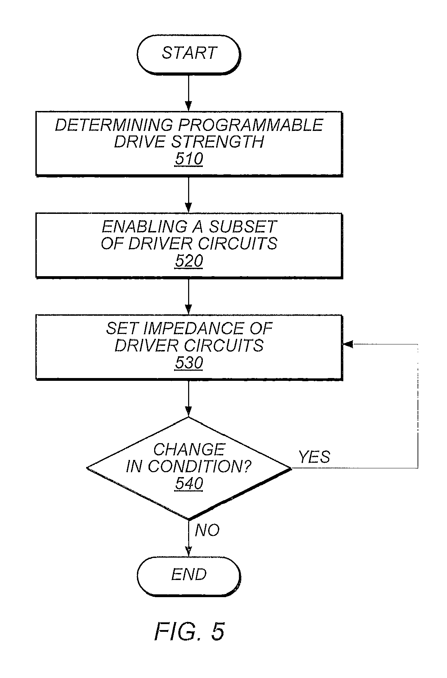

Referring to FIG. 5, a method for impedance control is shown according to some embodiments. At 510, the method may produce, receive, or otherwise determine a programmable drive strength signal. In some embodiments, one or more drive strength signals 220 may cause a number of driver circuits 300-320 of main driver circuit to engage in operation. In a non-limiting example, if each driver circuit 300-320 provides approximately 240 Ω of output impedance and it is desired that main driver circuit provide 60 Ω driver strength, then the driver strength select signal 220 will enable four (4) driver circuits in parallel with each other.

In some embodiments, calibration circuitry (not shown) within control circuit 180 may determine which drive strength to select in a particular situation. For example, a drive strength of 60 Ω may be suitable for a certain set of operating conditions or a specific load presented by external device 120. As these operating conditions or loads change over time, the calibration circuit may determine that a more appropriate drive strength is now 48 Ω, for example. As such, control circuit 180 may issue another or a different drive strength selection signal 220 that enables a fifth driver circuit in parallel with the first four (4) circuits, thus resulting in the desired 48 Ω drive strength. In some cases, control circuit 180 may itself be controlled software that allows it to respond to these variations in load or operating conditions by changing the drive strength of main driver 260 in a programmable manner.

At 520, the method may enable specific ones of driver circuits 300-320, for example, based on an initial operating condition. Typically, however, programmable drive strength may assume that each driver circuit 300-320 is capable of providing a fixed output impedance. Therefore, to ensure that main driver circuit 260 maintains a relatively constant output impedance that is approximately the desired fixed output impedance, control circuit 180 may also provide impedance control signals 230 that determine which sub-circuits (400a-z) within each drive circuit 300-320 are enabled at a given time (in addition to providing drive strength signals as discussed above). At 530, these impedance control signals, when processed by pre-driver logic 240, provide supplemental impedance control pull-up and pull-down signal pairs 250 to sub-circuits 400a-z of main driver 260.

At 540, the method may determine whether there is a change in operation condition that suggests or requires that impedance should be adjusted or modified. For example, operating conditions at output 190 may have changed (*e.g.* temperature increased or decreased, supply voltage increased or decreased, etc.). If so, control circuit 180 may provide modified impedance control signals 230 that modify which sub-circuits 400a-z of which driver circuits 300-320 should be enabled. Specifically, software may be executed periodically (*e.g.*, on the order of once a second or once every few seconds) to detect temperature changes and to modify the impedance controls to adjust for temperature changes. Because the series resistance of two or more sub-circuits is different from each other (*e.g.*, binary weighted), control circuit 180 has substantial flexibility in ensuring that each driver circuit 300-320 maintains an approximately constant output impedance, within the granularity possible via various parallel combinations of the sub-circuits 400a-z, and therefore enables main driver 260 to provide the selected drive strength as operating conditions vary.

In certain embodiments, control circuit 180 may be configured to provide impedance control signals 230 that independently enable different numbers of pull-up and pull-down transistors for each sub-circuit 400a-z for a same drive signal 210. For example, control circuit 180 may determine that three sub-circuits (*e.g.*, 400a-c) of a driver circuit (*e.g.*, 300) be enabled for a pull-up portion of drive signal 210, but only two sub-circuits (*e.g.*, 400a and 400b) of the same driver circuit for a pull-down portion of the drive signal. The selection of a different number of pull-up and pull-down transistors may be used, for example, to compensate for variations in the fabrication of the various transistors 410a-z and 420a-z in each sub-circuit 400a-z.

As shown in FIG. 1, the ESD protection circuit 130 may provide the primary ESD protection for the IC 100 with respect to ESD events that may occur on the pin 190. Moreover, poly resistors 430a-z may also provide supplemental ESD protection, protecting the corresponding transistors 410a-z and 420a-z while ESD protection circuit 130 dissipates the energy of the ESD event.

### Illustrative System

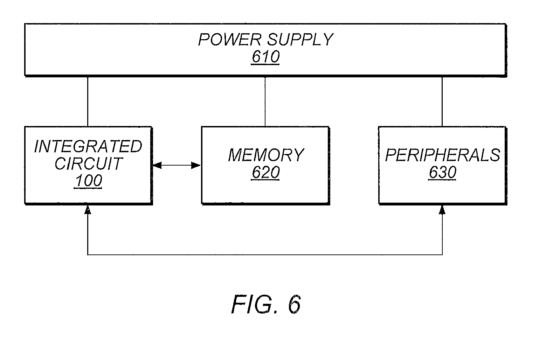

In some embodiments, a system may incorporate embodiments of the above described integrated circuit. Turning next to FIG. 6, a block diagram of such system is shown. As illustrated, system 600 includes at least one instance of integrated circuit 100. In some embodiments, integrated circuit 100 may be a system-on-chip (SoC) or application specific integrated circuit (ASIC) including one or more instances of core circuit 160, control circuit 180, driver circuit 140, etc. Integrated circuit 100 is coupled to one or more peripherals 630 and external memory 620, both of which are examples of external device 120. For example, integrated circuit 100 may include one driver for communicating signals to external memory 620 and another driver for communicating signals to peripherals 630. Power supply 610 is also provided which supplies the supply voltages to integrated circuit 100 as well as one or more supply voltages to memory 620 and/or peripherals 630. In some embodiments, more than one instance of integrated circuit 100 may be included (and more than one external memory 620 may be included as well).

Peripherals 630 may include any desired circuitry, depending on the type of system 600. For example, in an embodiment, system 600 may be a mobile device (*e.g.*, personal digital assistant (PDA), smart phone, etc.) and peripherals 630 may include devices for various types of wireless communication, such as Wi-Fi^{™}, Bluetooth^{®}, cellular, global positioning system, etc. Peripherals 630 may also include additional storage, including RAM storage, solid state storage, or disk storage. Peripherals 630 may include user interface devices such as a display screen, including touch display screens or multi-touch display screens, keyboard or other input devices, microphones, speakers, etc. In other embodiments, system 600 may be any type of computing system (*e.g.*, desktop and laptop computers, tablets, network appliances, mobile phones, personal digital assistants, e-book readers, televisions, and game consoles).

External memory 620 may include any type of memory. For example, external memory 620 may include SRAM, nonvolatile RAM (NVRAM, such as "flash" memory), and/or dynamic RAM (DRAM) such as synchronous DRAM (SDRAM), double data rate (DDR, DDR2, DDR3, etc.) SDRAM, Rambus^{®} DRAM, etc. External memory 620 may include one or more memory modules to which the memory devices are mounted, such as single inline memory modules (SIMMs), dual inline memory modules (DIMMs), etc.

Numerous variations and modifications will become apparent to those skilled in the art once the above disclosure is fully appreciated. It is intended that the following claims be interpreted to embrace all such variations and modifications.

## Claims

1. A driver circuit comprising:
a first pull-up transistor;
a first pull-down transistor coupled to the first pull-up transistor at a first node;
a first resistor coupled between the first node and an output pad;
a second pull-up transistor;
a second pull-down transistor coupled to the second pull-up transistor at a second node; and
a second resistor coupled between the second node and the output pad.

2. The driver circuit of claim 1, wherein the first and second pull-up transistors are p-type transistors, the first and second pull-down transistors are n-type transistors, and the first and second resistors are poly resistors.

3. The driver circuit of claim 1 or 2, wherein a first resistance of the first resistor is different from a second resistance of the second resistor.

4. The driver circuit of claim 3, wherein the second resistance is approximately twice as large as the first resistance.

5. The driver circuit of any of claims 1-4, wherein the first resistor has a resistance that is approximately 4 times larger than a resistance of the first pull-up transistor or the first pull-down transistor.

6. The driver circuit of any of claims 1-5, wherein a first series resistance of the first pull-up transistor and the first resistor is configured to yield a specified output impedance under a first circuit condition.

7. The driver circuit of claim 6, wherein a second series resistance of the second pull-up transistor and the second resistor in parallel with the first series resistance is configured to maintain the specified output impedance under a second circuit condition different from the first circuit condition.

8. The driver circuit of any of claims 1-7, further comprising:
a third pull-up transistor coupled to a third pull-down transistor at a third node, and a third resistor coupled between the third node and the output pad, wherein a third resistance of the third resistor is approximately twice as large as a second resistance of the second resistor and approximately four times as large as a first resistance of the first resistor.

9. An integrated circuit comprising:
a control circuit configured to generate control signals; and
a plurality of driver circuits coupled to the control circuit, wherein each of the plurality of driver circuits is configured to receive a corresponding one or more of the control signals, wherein each of the plurality of driver circuits comprises a plurality of sub-circuits, and wherein each of the plurality of sub-circuits includes a driver circuit as recited in any of claims 1-8.

10. The integrated circuit of claim 9, wherein the control circuit is configured to generate the one or more of the control signals to enable selected ones of the plurality of driver sub-circuits within a given driver circuit and control an impedance of the given driver circuit.

11. The integrated circuit of claim 9 or 10, wherein the control circuit is configured to generate the one or more of the control signals to enable selected ones of the plurality of driver circuits and control a drive strength the plurality of the driver circuits.

12. A method comprising:
determining a programmable drive strength of an interface circuit having a plurality of driver circuits;
enabling a subset of the plurality of driver circuits based, at least in part, on the programmable drive strength; and
setting, based at least in part on an operating condition of the interface circuit, an impedance of one or more driver circuits within the subset of enabled driver circuits, wherein each driver circuit comprises a first pull-up transistor coupled to a first pull-down transistor at a first node, and a first resistor coupled between the first node and an output pad; and a second pull-up transistor coupled to a second pull-down transistor at a second node, and a second resistor coupled between the second node and the output pad.

13. The method of claim 12, wherein setting the impedance of the one or more driver circuits comprises:
enabling one or more of the first pull-up transistor and the second pull-up transistor; and
enabling one or more of the first pull-down transistor and the second pull-down transistor.

14. The method of claim 12 or 13, further comprising adjusting the impedance of the one or more driver circuits based at least in part on a change in the operating condition.

15. The method of claim 14 wherein adjusting the impedance comprises enabling different ones of a plurality of pull-up or pull-down transistors including the first and second pull-up transistors and the first and second pull-down transistors.
